Europäisches Patentamt

**European Patent Office**

Office européen des brevets

(11) Publication number: **0 109 853**
**A2**

(12) **EUROPEAN PATENT APPLICATION**

(21) Application number: **83307114.5**

(22) Date of filing: **21.11.83**

(51) Int. Cl.³: **H 01 L 27/10**
**H 01 L 29/60**

(30) Priority: **23.11.82 US 444256**
**25.01.83 US 460730**

(43) Date of publication of application:
**30.05.84 Bulletin 84/22**

(84) Designated Contracting States:
**AT DE FR GB IT NL SE**

(71) Applicant: **AMERICAN MICROSYSTEMS,
INCORPORATED
3800 Homestead Road
Santa Clara, CA 95051(US)**

(72) Inventor: **Batra, Tarsaim Lal
10316 Virginia Swan Place
Cupertino California 95014(US)**

(74) Representative: **Jones, Ian et al,
POLLAK MERCER & TENCH High Holborn House 52-54
High Holborn
London WC1V 6RY(GB)**

(54) Semiconductor memory devices and methods for making the same.

(57) An array of MOS transistors (30) formed in a semiconductor substrate having a plurality of continuous diffused lines (bit lines) (7-3, 7-4, 7-5 and 7-6) serving as the source and drain regions of a plurality of MOS transistors. A plurality of conductive word lines (33, 133) are formed over the plurality of diffused lines, crossing the diffused lines at substantially right angles, with each conductive word line serving as the gates of a plurality of MOS transistors. Each transistor of the memory array is formed in a region containing two continuous diffused lines and a single word line. A single electrical contact (36-3, 4, 5, 6) to a bit line is formed for each such diffused line.

FIG. 3a

EP 0 109 853 A2

-1-

SEMICONDUCTOR MEMORY DEVICES AND METHODS FOR MAKING
THE SAME

DESCRIPTION

This invention relates to semiconductor memory devices and to methods for making semiconductor memory devices. -

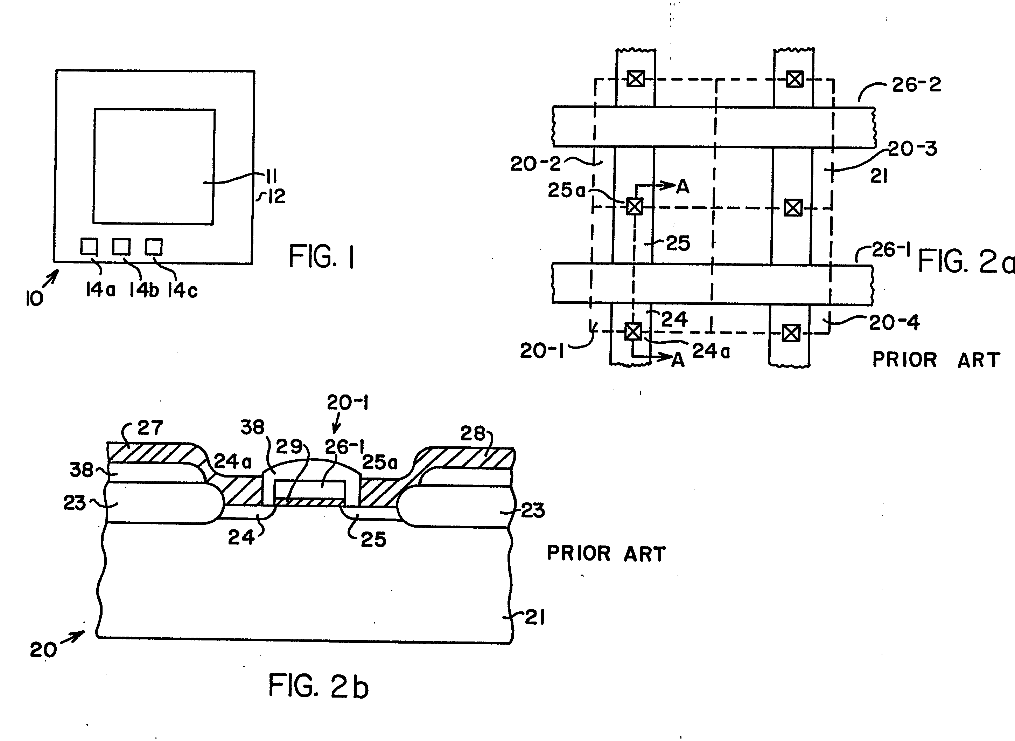

The prior art is described below with reference to Figures 1, 2a and 2b of the accompanying drawings, in which:

Figure 1 is a plan view of a typical semiconductor memory circuit;

Figure 2a is a plan view of a typical prior art MOS transistor utilized in prior art memory cells; and

Figure 2b is a cross-sectional view of the prior art MOS transistors which form a portion of a memory array, as shown in the plan view of Figure 2a.

MOS transistors are well known in the art as are memory circuits utilizing a plurality of such MOS transistors formed as a monolithic integrated circuit in a single piece of semiconductor material. A plan view of such an integrated circuit memory device is shown in Figure 1. Memory device 10 includes a core region 11 containing an array comprising a large number of memory cells, each memory cell capable of storing a single binary digit ("bit"). Modern memory circuits are capable of storing as many as 256k (1k = 1024) bits and thus such a 256k memory circuit contains 262,144



-2-

memory cells within core region 11.  Surrounding core region 11 is peripheral region 12, which contains devices other than the memory cells contained in core region 11.  Such other devices typically include decoders, for decoding a binary address input word typically comprising a number of bits which define the desired cell or cells within core region 11 to be accessed. Other so called "peripheral circuits" contained within peripheral region 12 are input buffers and output buffers, which translate between the relatively high level signals utilized by external circuitry (not shown) to the relatively low level signals utilized by the memory cells contained within core region 11. Also contained within peripheral region 12 are bonding pads, such as bonding pads 14a through 14c, which allow connection of a very small (typically 0.001 inch in diameter) wire between each bonding pad and the leads of a package or substrate (not shown), thereby allowing electrical connection between external devices (not shown) and circuit 10. Of importance, the MOS transistors utilized to form memory cells within core region 11 are formed in precisely the same manner, and at the same time, as the MOS transistors utilized to form peripheral circuitry within peripheral region 12. However, the peripheral circuitry includes certain MOS transistors which are physically larger than the MOS transistors contained within core region 11 simply because certain MOS transistors of the peripheral circuitry such as the input and output protection devices are required to be exposed to higher voltage and current levels than are the MOS transistors within core region 11. However, apart from the size difference of certain transistors in peripheral region 12, the MOS transistors formed within core region 11 and peripheral region 12 are substantially identical.

Read only memories (ROM) are well known to those in the art. Such ROMS typically comprise a plurality of MOS transistors formed in an array. During fabrication, each transistor is selectively formed to store either a logical zero or a logical one. A transistor which stores a value of logical one, for example, will typically have a threshold voltage (i.e., the voltage required to be placed on the transistor's control gate in order to cause the transistor to turn on) of approximately 0.8 volts, while a transistor which stores a logical zero is fabricated to have a threshold voltage of approximately five volts or more. When a selected transistor is accessed utilizing well known decoding and accessing techniques, a read voltage $V_r$ between the threshold voltage of a transistor which stores a logical zero and the threshold voltage of a transistor which stores a logical one is placed on the control gate of the selected transistor. If the selected transistor turns on, it is known that the selected transistor has a threshold voltage less than the read voltage $V_r$ applied to its control gate, or in other words, stores a logical one. Conversely, if it is determined that the selected transistor does not turn on, it is known that its threshold voltage is greater than the read voltage $V_r$ applied to its control gate, or in other words, the selected transistor stores a logical zero. Whether the selected transistor is turned on is detected, for example, by utilizing a sense amplifier of a type which is well known to those of ordinary skill in the art, and thus, such a sense amplifier will not be described in further detail here. One such ROM is described in United States Patent No. 4,350,992.

A plan view of a portion of core region 11 of the structure of Figure 1 utilizing typical prior art MOS transistors 20-1 through 20-4 is shown in Figure 2a. MOS transistors 20-1 through 20-4 are formed in, for example, a P type silicon substrate 21. Formed on the surface of silicon substrate 21 is a thin layer of oxide upon which conductive word lines 26-1 and 26-2 are formed. Word lines 26-1 and 26-2 typically comprise doped polycrystalline silicon having a relatively low resistivity (typically 20-40 ohms per square). The remainder of this description will refer only to transistor 20-1, although it is understood that transistors 20-2 through 20-4 are manufactured simultaneously with, and operate the same as, transistor 20-1. It is also understood that generally a large number of transistors are formed, thereby providing a core region having a large number of memory cells.

After the word lines 26-1 and 26-2 are formed, N type source and drain regions 24 and 25, respectively, are formed, typically utilizing word line 26-1 as a mask in order to provide self-alignment of source region 24 and drain region 25 to the edge of word line 26-1. In this manner, source 24 and drain 25 are guaranteed to be formed adjacent to and, due to lateral diffusion of dopants, extend slightly beneath word line 26-1, thereby insuring the proper operation of MOS transistor 20-1. Of importance, each such transistor within the core region 11 must include source contact 24a and drain contact 25a for connection to a pair of conductive bit lines (not shown). The requirement that each source and drain region of transistor 20-1 include contact regions 24a and 25a, respectively, requires that source 24 and drain 25 be made rather large in order to provide room for the relatively large electrical contacts 24a and 25a. Electrical contacts 24a and 25a typically measure approximately 3 microns by 3 microns and are required to be rather large in order to provide a reliable low resistance electrical connection between the bit lines (not shown) and source region 24 and drain region 25. In order to accommodate such electrical contacts, source and drain regions 24 and 25 are typically 6 microns wide, in order to provide a suitable tolerance in order to insure that the contact is formed complete within the desired source and drain regions 24 and 25. Because each transistor within core region 11 must be electrically connected to two contact regions, each cell within core region 11a is rather large, thereby limiting the number of transistors which may be contained within a core region 11 of a given size. Put in another way, for a given memory size (i.e., 256k) requiring a given number of transistors within core region 11, a rather large core region 11 is required because of the rather large size of each cell within core region 11.    Accordingly, a rather large piece of semiconductor material is required to form the memory device 10 (Figure 1), limiting the number of devices which are formed on a single semiconductor wafer, thereby causing each memory circuit 10 to be rather expensive.

A cross-sectional view of transistor 20-1 taken along line AA of Figure 2a is shown in Figure 2b. Formed in silicon substrate 21 are N type source 24 and N type drain 25.    Located above and separated from silicon substrate 21 by gate dielectric layer 29 is word line 26-1 serving as the gate of transistor 20-1.    Gate 26-1 and field oxide 23 are covered with a layer of glass 38.    Contact regions 24a and 25a are shown, allowing electrical connection between electrical interconnects 27, 28 and source 24 and rain 25, respectively.

The present invention provides a semiconductor memory device having a plurality of cells, each cell comprising an MOS transistor having a source, a drain, a gate, and a channel, and each cell being capable of storing a single binary digit, the device comprising:

a semiconductor substrate of a first conductivity type;

a first doped region of a second conductivity type opposite the first conductivity type;

a second doped region of the second conductivity type;

a plurality of channel regions located between the first and second doped regions;  and

a plurality of conductive lines, each conductive line being located above and insulated from an associated one of the channel regions by an insulation layer;

the first doped region serving as the source of each cell, the second doped region serving as the drain of each cell, each conductive line serving as the gate of one of the plurality of cells, and the portion of the substrate between the first and second doped regions and beneath each conductive line serving as the channel of one of the plurality of cells.

In one embodiment of this invention, the array of MOS transistors is formed in the semiconductor substrate together with a plurality of continuous diffused lines serving as the source and drain regions of the MOS transistors and which are often referred to as "bit lines". A plurality of the conductive lines or "word lines" are formed over the plurality of diffused lines and across the plurality of diffused lines at substantially right angles, with each conductive word line serving as the gate of a plurality of MOS transistors. The diffused lines can be diffused continuously, even under the conductive word lines.

In contrast to prior art MOS transistors, each transistor of the memory array constructed in accordance with this invention is formed not at the intersection of a single, noncontinuous diffused line and a single word line, but in a region containing two continuous diffused lines and a single word line. Because each diffused line is continuous, being diffused even under each conductive word line which crosses above it, electrical contacts to bit lines are not required for each transistor, but rather a single contact to a bit line can be formed for each such diffused region. The diffused lines can be made substantially narrower than the diffused lines of prior art MOS transistors and the transistor cells within a memory array can be substantially smaller and closer together than the MOS transistors used in prior art memory arrays, because the number of electrical contacts to bit lines is substantially reduced compared to such prior art circuits. Because the number of contacts is significantly reduced as compared to prior art memory circuits, the diffused regions can be made much smaller and the number of memory cells formed in a core area of a given size is substantially increased as compared to the prior art.

In another embodiment of this invention, an EPROM can be fabricated in a similar fashion, with the addition of a floating gate in each memory cell transistor.

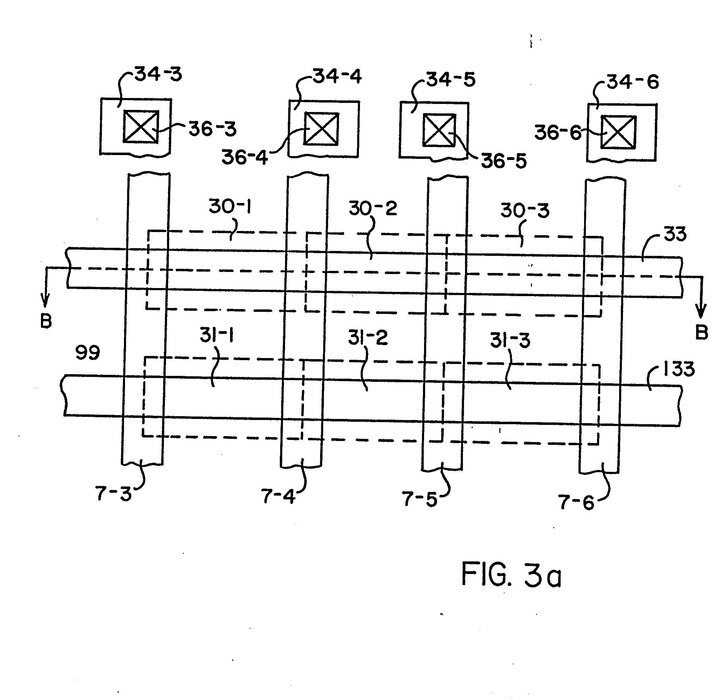

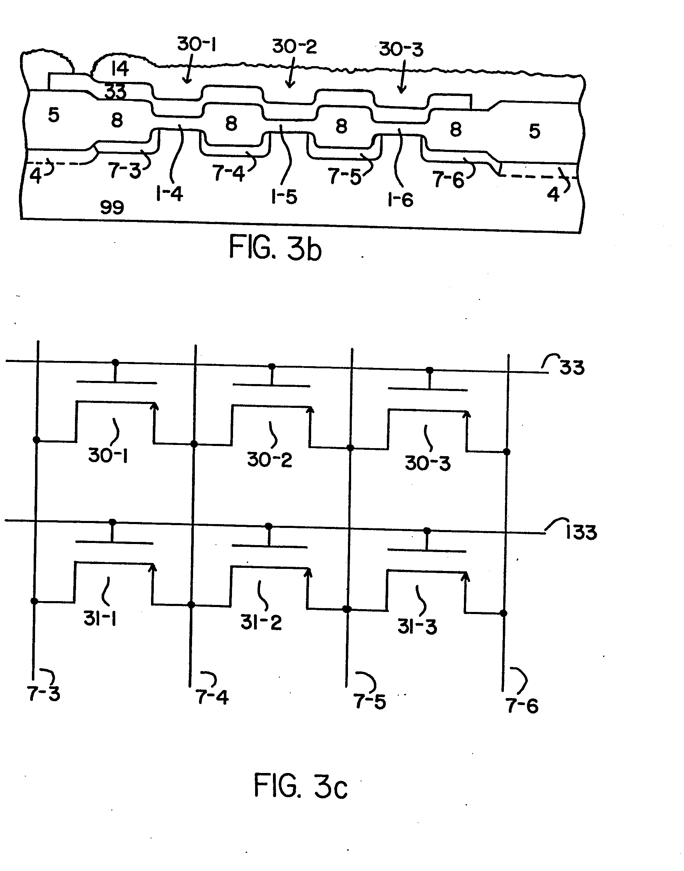

Embodiments of the invention are described below by way of illustration and with reference to Figures 3 to 6 of the accompanying drawing, in which:

Figure 3a is a plan view of one memory array constructed in accordance with this invention;

Figure 3b is a cross-sectional view taken along line BB of Figure 3a;

Figure 3c is a schematic diagram depicting the memory array of Figure 3a;

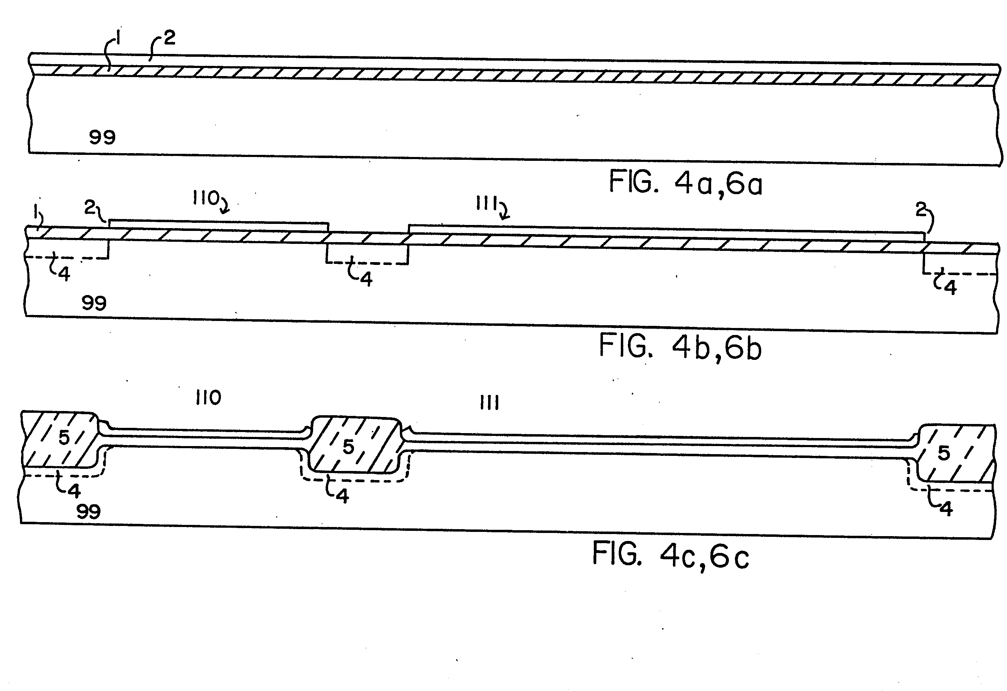

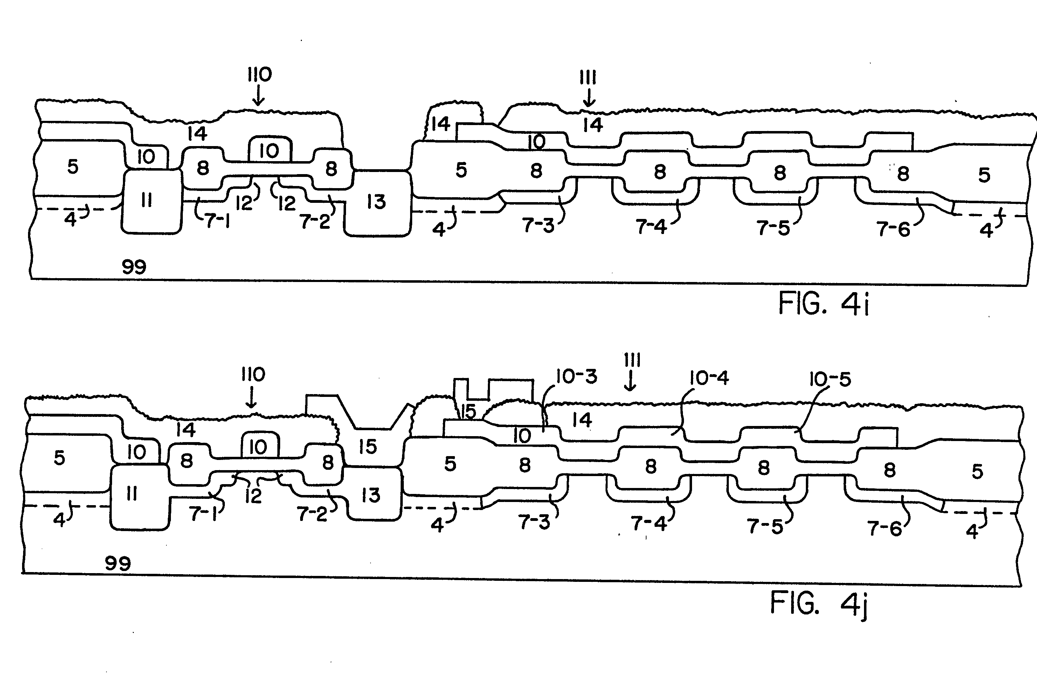

Figures 4a to 4j are cross-sectional views depicting the fabrication of a memory device in accordance with the invention;

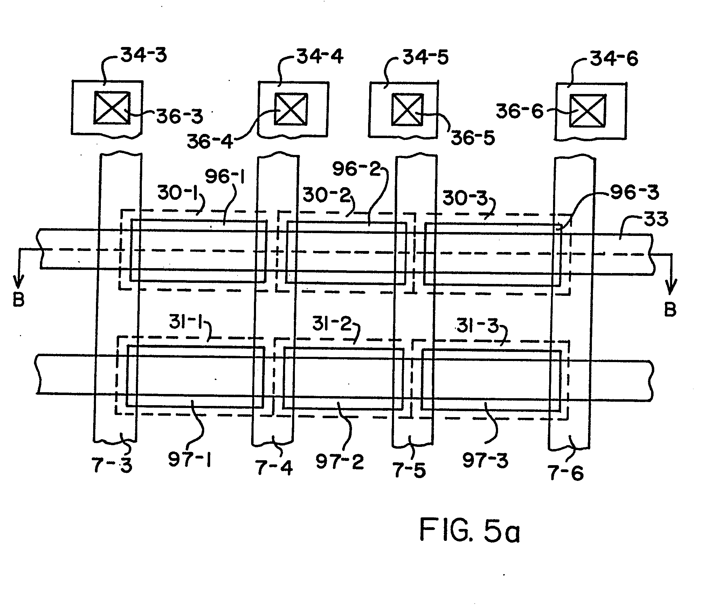

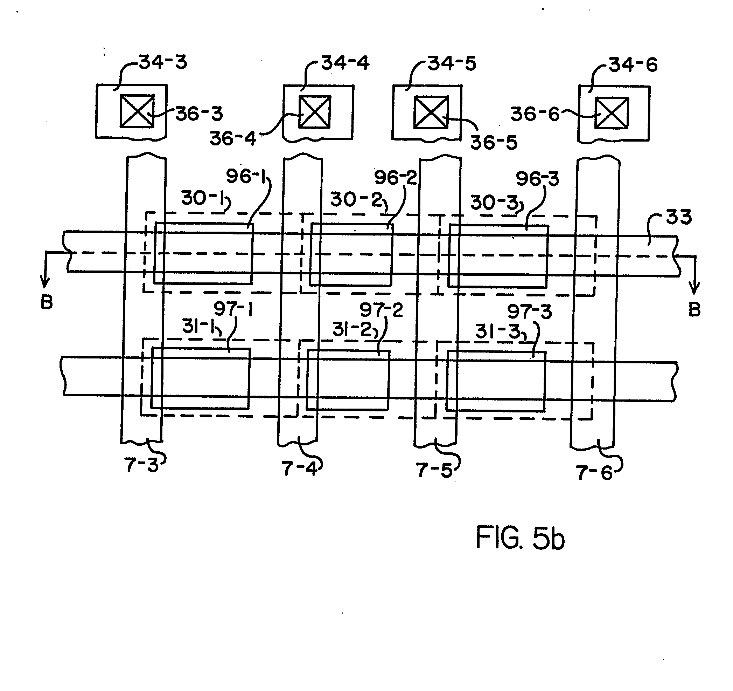

Figures 5a and 5b are respectively plan views of two different EPROMs constructed in accordance with this invention; and

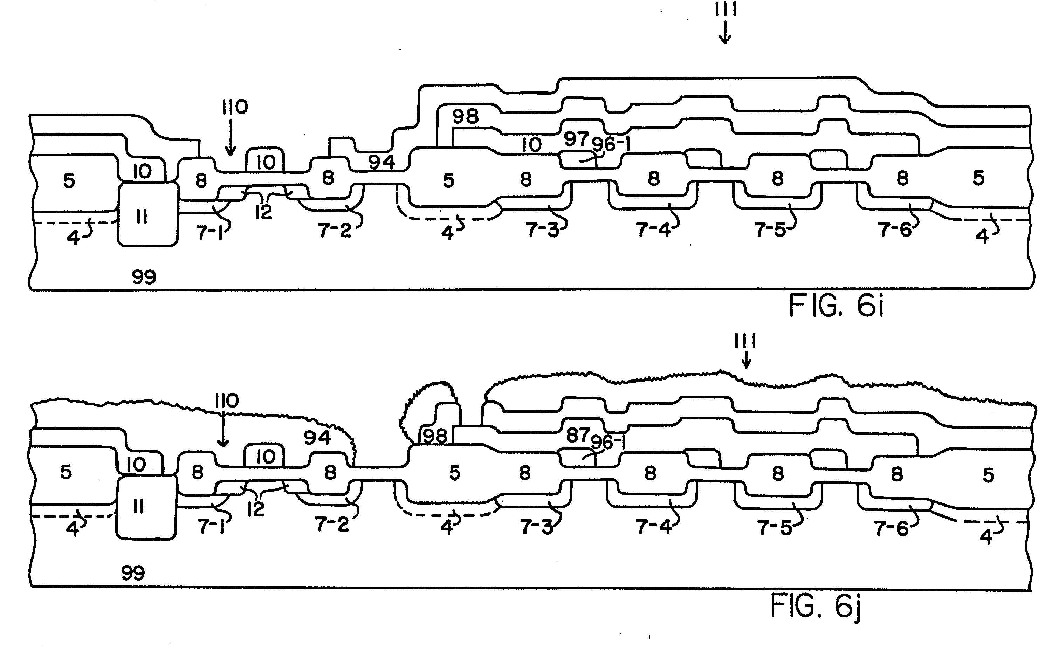

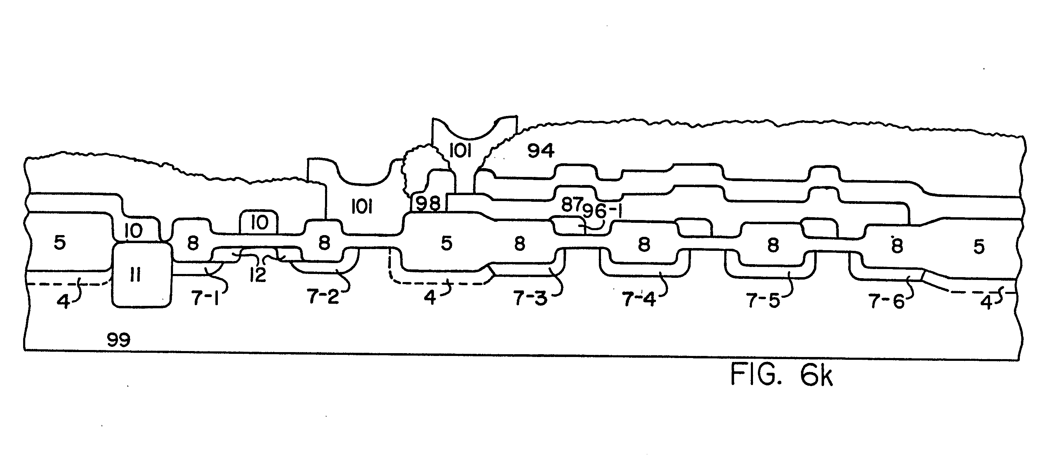

Figures 6a through 6h are cross-sectional views depicting the fabrication of an EPROM in accordance with this invention.

A plan view of a portion of a memory device constructed in accordance with this invention, and including transistors 30-1 through 30-3 and 31-1 through 31-3, is shown in plan view in Figure 3a. Formed within a semiconductor body 99 are diffused lines or regions 7-3 through 7-6. Formed above and insulated from diffused regions 7-3 through 7-6 is word line 33, serving as the gate of MOS transistors 30-1 through 30-3, and word line 133, serving as the gate of MOS transistors 31-3 through 31-3. The operation and fabrication of MOS transistors 31-1 through 31-3 is similar to the operation and fabrication of MOS transistors 30-1 through 30-3, and thus the remainder of this specification is directed towards MOS transistor 30-1 through 30-3, and in particular to transistor 30-1.

In contrast to prior art MOS transistors, the diffused lines or regions 7-3 and 7-4 are formed before the formation of word lines 33 and 133, and thus diffused lines 7-3 and 7-4 form continuous diffusions, even under word lines 33 and 133. Furthermore, in contrast to prior art MOS transistors, the transistor 30-1 constructed in accordance with this invention does not include within a single noncontinuously diffused region a source region and a drain region located on opposite sides of a word line, but rather utilize a continuous diffused region 7-3 as its source, diffused region 7-4 as its drain, and the channel region of transistor 30-1 is formed beneath word line 33 between source region 7-3 and drain region 7-4. Because diffused regions 7-3 and 7-4 are continuous, a large number of transistors are formed utilizing a single diffused region 7-3 to form the source regions of this plurality of transistors, and a single diffused region 7-4 to form the drain regions of the plurality of transistors. Diffused region 7-4 also forms the source of a plurality of transistors, such as transistors 30-2 and 31-2, with diffused region 705 serving as their drains.

Furthermore, because diffused regions 7-3 and 7-4 are continuous, a single electrical contact 36-3 is used to provide electrical connection to a plurality of source regions formed by diffused line 7-3, and a single electrical contact 37-3 is used to provide electrical connection to a plurality of drain regions formed by diffused line 7-4. In this manner, diffused lines 7-3 and 7-4 are made substantially narrower than the diffused lines used in the prior art, with only

0109853

-10-

relatively small portions 34-3 and 34-4 of diffused lines 7-3 and 7-4, respectively, being made sufficiently large to accommodate the formation of electrical contacts 36-3 and 36-4, respectively, therein.   In accordance with this invention, a ROM is formed having source drain diffusions 7-3 and 7-4 which are only approximately 3 microns wide except, of course, for regions 34-3 and 35-4 which are made sufficiently large to accommodate the single electrical contacts required for each diffused regions 31 and 32.   In one embodiment, a ROM is fabricated in which diffused regions 7-3 through 7-6 are fabricated to extend into the peripheral region, contacts 36-3 through 36-6 are formed in the peripheral region, and thus the core region contains no contacts.   Accordingly, a memory core cell is formed utilizing the small transistors (i.e. a typical cell of 6 microns square) constructed in accordance with this invention which is much more dense than the memory cores constructed using prior art MOS transistors.

A cross-sectional view taken along line BB of Figure 3a is shown in Figure 3b depicting transistor 30-1. Within substrate 21 are formed diffused regions 7-3 through 7-6. Formed on all sides of the core region is relatively thick field oxide 5 having a typical thickness within the range of 6000Å to 7000Å. Formed above the greater portion of diffused regions 7-3 through 7-6 along their entire length is relatively thin field oxide 8 having a typical thickness within the range of approximately 3500Å to 4500Å. Thin field oxide 8 serves to minimize the capacitance between both polycrystalline silicon interconnect 10 (word line 33) and other conductive lines (not shown) and substrate 21. This reduced capacitance increases the speed of the device, although it is understood that this thin field oxide 8 is not essential if somewhat higher capacitances are tolerable. Formed above the remaining portion of diffused regions 7-3 through 7-6, and above the channel regions located therebetween, is gate dielectric 1-4 having a typical thickness within the range of 500Å to 600Å. Formed above thick field oxide 5, thin field oxide 8, and gate dielectric 1-4 through 1-6 and running substantially perpendicular to diffused regions 7-3 through 7-6 is word line 33 serving as the gate of transistors 30-1 through 30-3.

Referring again to Figure 3a, a thick field oxide (not shown, and typically 6000-7000Å in thickness) is formed between cells (for example, in the region bounded by diffused regions 7-3, 7-4 and polycrystalline silicon 33, 133. This thick field oxide serves to minimize coupling between cells, increase the field inversion voltage, and minimize capacitance between the substrate 29 and any overlying conductive regions. It is understood, however, that this field oxide is not essential if these features are not required.

Figure 3c is a schematic diagram of the ROM device constructed in accordance with this invention. Polycrystalline silicon lines 33 and 133, which form the gates of transistors 30-1 through 30-3 and 31-1 through 31-3, is referred to as the "word line" of the device. Similarly, diffused regions 7-3 through 7-6 are referred to as the "bit lines" of the device. In order to read the contents of a selected cell, the selected cell's word line is brought high (to the read voltage Vr, its drain is brought high (typically 5 volts), and its source is brought low (typically ground). The read voltage Vr is greater than the threshold voltage of a cell containing a logical one and is less than the threshold voltage of a cell containing a logical zero. Thus, if a logical one is stored, the cell conducts, and if a logical zero is stored, the cell does not conduct. Of importance, this selected read voltage Vr is applied to only one word line 33, 133 crossing diffused lines 7-3 through 7-6 in order to access only the transistors on a single word line at any given time. If the selected cell stores a logical one (i.e., a threshold voltage less than Vr) it will conduct. Conversely, if the selected cell stores a logical zero (i.e., a threshold voltage greater than Vr) it will not conduct. For example, if it is desired to read the contents of cell 30-1, word line 33 is brought high (Vr) and word line 133 is kept low (typically ground). A positive voltage (typically 5 volts) is placed on the drain 7-3 of memory cell 30-1, and the source 7-4 of cell 30-1 is connected to ground. The remaining bit lines 7-5 and 7-6 are kept floating at this time. Whether cell 30-1 turns on is detected by a sense amplifier (not shown) of well-known design which detects current flow through diffused region 7-3. Because word line 133 is kept low at this time, cells 31-1 throught 31-3 do not turn on, regardless of whether they store a logical one or a logical zero. Furthermore, because cells 30-2 and 30-3 each receive low voltages on their source and drains (diffused regions 7-4 through 7-6) cells 30-2 and 30-3 cannot turn on, regardless of whether they store a logical one or a logical zero.

In practice, it is often desirable to construct a ROM which is capable of being read on a word-by-word basis where, for a given address signal, a plurality of cells are read simultaneously and the bits stored therein provided as output signals from the ROM. One technique of doing this is to include a large number of diffused regions, such as diffused regions 7-3 through 7-6, thereby forming a large plurality of memory cells along each word line. Then, during the read operation, rather than accessing a single cell along a word line, a plurality of cells along a word line are accessed, thereby providing a plurality of output bits during each read operation. In order to prevent false detection of a logical one bit due to conduction of nonselected cells along the selected word line, the cells along a word line which form a plurality of bits of a single word will be spaced apart by a large number of cells, typically 16 or 32. For example, in one embodiment of this invention, an eight bit word is read for each address. In this embodiment, each word line contains a plurality of 256 (i.e., 32 times 8) memory cells 30-1 through 30-256. The first 8 bit word formed by word line 33 is provided by the eight memory cells 30-1, 30-33, 30-65, 30-97, 30-129, etc. The second 8 bit word provided by word line 33 is provided by memory cells 30-2, 30-34, 30-66, 30-98, etc. In this manner, the current flow through the large number (i.e., 31) of unselected cells between two selected cells on the selected word line is sufficiently small due to the rather large resistance of 32 series connected transistors to prevent the sense amplifier (not shown) from detecting this small current flow as a logical one bit, and thus the sense amplifier provides a logical one output signal only when the selected cell is actually conducting. Suitable addressing and decoding techniques well-known to those of ordinary skill in the art are used to select the appropriate word line and the appropriate cell or cells along the selected word line in order to read the memory device constructed in accordance with this invention.

Figures 4a-4j depict one fabrication process used to manufacture an MOS ROM in accordance with one embodiment of this invention. As shown in Figure 4a, a P type silicon substrate 99 having a <100> type crystal orientation and a resistivity within the range of approximately 30 to 60 ohm-cm is used. Formed on silicon substrate 99 is oxide layer 1 having a thickness within the range of approximately 450Å to 550Å. Oxide layer 1 is formed, for example, by thermal oxidation in wet oxygen at approximately 1050°C for approximately 10 minutes. Formed on oxide layer 1 is silicon nitride layer 2, formed to a thickness within the range of approximately 700Å to 1600Å. Silicon nitride layer 2 is formed, for example, by well known chemical vapor deposition techniques. As shown in Figure 4b, nitride layer 2 is then defined, for example by utilizing well known photolithographic techniques, and patterned (for example by etching with $CF_4$ plasma) to remove selected portions of nitride layer 2 in order to expose the to-be-formed field oxide regions (other than the field oxide regions within the core region 111), and leaving nitride layer 2 over the peripheral region 110 and the core region 111. If desired, dopants are now introduced into the field region exposed by patterned nitride layer 2, as shown by the dashed lines labeled 4, in order to provide the desired field threshold voltage, as is well known in the semiconductor art. These P type dopants are introduced, for example, by the ion implantation of boron through the exposed portions of oxide layer 2 at an energy level of approximately 100 Kev to a dosage of approximately 5.3 x $10^{12}$ atoms/cm$^2$.

Referring to Figure 4c, field oxide 5 is now formed in the regions exposed by nitride layer 2, with nitride layer 2 serving as a mask effectively preventing the growth of oxide on portions of substrate 99 covered by nitride layer 2. Field oxide 5 is grown to a thickness within the range of approximately 5800Å to 7200Å, for example, by increasing the temperature of the wafer to approximately 850°C within 5 minutes in an atmosphere of nitrogen and oxygen, followed by increasing the temperature of the wafer to approximately 950°C within approximately 10 minutes in a nitrogen/oxygen atmosphere, followed by exposing the wafer to wet oxygen at approximately 950°C for approximately 220 minutes, followed by exposing the wafer to nitrogen at approximately 950°C for approximately 10 minutes, followed by reducing the temperature of the wafer to room temperature in a nitrogen atmosphere within approximately 20 minutes. Field dopants are simultaneously redistributed, as shown by the dashed lines 4, thereby establishing the desired field threshold voltage of approximately ten volts or more.

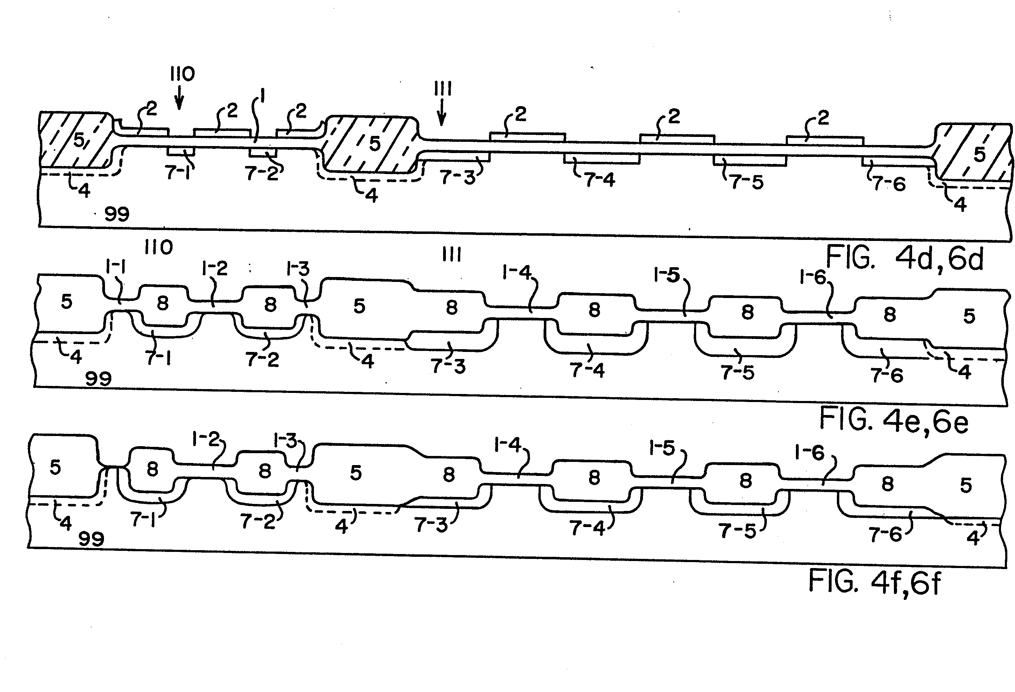

Active peripheral devices are now formed within peripheral region 110. Similarly, the core transistors are now formed within core region 111. Referring to Figure 4d, the remaining portions of nitride layer 2 are defined, for example utilizing well known photolithographic techniques, and patterned, for example by etching with $CF_4$ plasma, to expose portions of oxide layer 1 beneath which are to be formed N type source/drain regions 7-1 through 7-6. At this time, oxide layer 1 and nitride layer 2 remain in those areas where active devices in peripheral region 110 are to be formed, where contacts are to be formed, and in areas which are to become the channels of the core transistors. N type source/drain regions 7-1 through 7-6 are then formed, for example, by the implantation of arsenic ions at approximately 75 Kev to a dosage of approximately $8 \times 10^{15}$ atoms/$cm^2$. Alternatively, the

exposed portions of oxide layer 1 are removed and N type source/drain regions 7-1 through 7-6 formed by well known diffusion techniques.

As shown in Figure 4e, thin field oxide layer 8 is formed over substantially the entire length and over the major portion of the width of each source/drain region 7-1 through 7-6 to a thickness within the range of approximately 3500 to 4500 Angstroms, for example, by increasing the temperature of the wafer to approximately 950°C within approximately 5 minutes in a nitrogen atmosphere, followed by oxidation in wet $O_2$ at approximately 950°C for approximately 45 minutes, followed by oxidation in dry $O_2$ at approximately 950°C for approximately 5 minutes, followed by decreasing the temperature of the wafer to room temperature within approximately 10 minutes in a nitrogen atmosphere. During the formation of thin field oxide region 8, the dopants within source/drain regions 7-1 through 7-6 are diffused as shown in Figure 4e. The thickness of thick field oxide layer 5 is increased slightly at this time, to a thickness of approximately 7000$\overset{o}{A}$. The remaining portions of nitride layer 2 and oxide layer 1 are then removed, for example by first etching nitride layer 2 with $CF_4$ plasma and then etching oxide layer 1 with HF. The wafer is then further oxidized to form gate oxide layers 1-1 through 1-6 to a thickness within the range of approximately 500$\overset{o}{A}$ to 600$\overset{o}{A}$, for example, by oxidation in dry oxygen containing approximately 3 percent HCl at approximately 950°C for approximately 90 minutes. The thicknesses of thin field oxide layer 8 and thick field oxide layer 5 are increased slightly during these steps, although this slight increase in thickness is unimportant. Oxide layer 1-2 within peripheral region 110 will serve as the gate insulation for the MOS transistors formed in the peripheral region, and oxide layers 1-4 through 1-6 within core region 111 will serve as the gate insulation for MOS transistors 10-1 through 10-3, respectively, formed within the core region 111.  If desired, the wafer is then processed through various masking and doping steps in order to adjust the threshold voltages of the transistors being fabricated, as is well known to those of ordinary skill in the art.

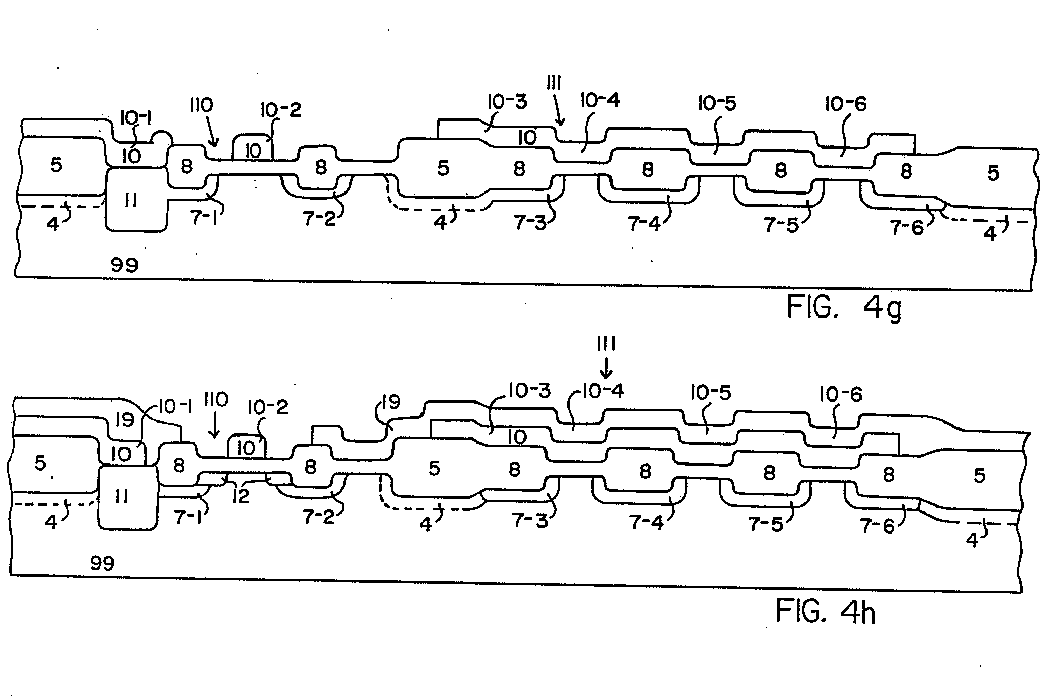

Referring to Figure 4f, gate oxide 1-1 is removed in order to allow the formation of N type buried contact region 11 (Fig. 4g).  Buried contact region 11 allows electrical contact to source/drain region 7-1.  Peripheral buried contact region 11 is formed, for example, using suitable well known photolithographic techniques to define the location of to-be-formed buried contact region 11, thereby exposing oxide 1-1.  Oxide 1-1 is then removed, for example, by etching with buffered HF, thereby exposing the location within substrate 99 where buried contact region 11 is to be formed.

Referring to Figure 4g, a layer of polycrystalline silicon 10 is formed on the surface of the device to a thickness within the range of approximately $3650\overset{\circ}{A}$ to $4350\overset{\circ}{A}$, for example, by well known low pressure chemical vapor deposition.  Polycrystalline silicon layer 10 is then doped, for example, by utilizing $POCl_3$ as a dopant source at approximately 970°C., thereby increasing the conductivity of polycrystalline silicon layer 10 to within the range of approximately 20 to 40 ohms/square.  Polycrystalline silicon layer 10 is then defined, for example utilizing well known photolithographic techniques, and patterned, for example by etching with $CF_4$ plasma, thereby forming the desired electrical interconnect pattern, as shown in Figure 4g.  Polycrystalline silicon layer 10 thus forms electrical interconnect 10-1 providing electrical contact to source/drain region 7-1 through peripheral source/drain contact region 11, peripheral gate region 10-2, electrical interconnect 10-3 (corresponding to word line 33 of Fig. 3a) formed above thick field oxide region 5 and thin field oxide region 8, which provides core gate regions 10-4 through 10-6 for transistors 30-1 through 30-3 (Fig. 3a), respectively. The dopants introduced into buried contact region 11 by the formation of polycrystalline silicon layer 10 are diffused into substrate 99 during the reflowing of to-be-formed glass layer 14 (Figures 4i and 4j) which is fully described later, thereby completing the formation of buried contact 11.

As shown in Figure 4h, dopants are introduced into source/drain extensions 12 within peripheral region 110 in order to complete the fabrication of the source and drain regions of the peripheral device. This source/drain completion step is performed, for example, by applying a layer of photoresist 19 over the entire surface of the wafer, and patterning the photoresist utilizing well-known photolithographic techniques to expose the peripheral transistor. Source/drain extensions 12 are then formed, for example, by the ion implantation of arsenic at approximately 75 Kev to a dosage of approximately $6 \times 10^{15}$ atoms/cm$^2$. Of importance, the photoresist layer 19, the exposed portions of thin field oxide region 8, and polycrystalline silicon gate region 10-2 serve as a mask during the implantation of dopants to form source/drain region extensions 12, thereby assuring that the source/drain region extensions 12 are formed where desired and are self-aligned to peripheral region gate 10-2. Photoresist layer 19 is then removed. These arsenic dopants in source/drain extensions 12 are then diffused, for example by increasing the temperature of the wafer to approximately 900°C within approximately 10 minutes in a dry oxygen atmosphere, followed by maintaining the wafer at approximately 900°C for approximately 90 minutes in a dry oxygen atmosphere, followed by approximately 900°C for approximately 10 minutes in a nitrogen atmosphere, followed by decrease in the temperature of the wafer to room temperature within approximately 10 minutes in a nitrogen atmosphere.

A second field implant is used to increase the field inversion voltage in the core area to in excess of 7 volts. This implant is performed, for example, by implanting boron at approximately 50 KEV to a dosage of approximately $1.5 \times 10^{12}$ ions/cm$^2$.

If desired, selected MOS transistors in the core area 111 are now programed. This programming is performed, for example, by applying a layer of photoresist (not shown) and patterning the photoresist in a well known manner to expose those MOS transistors within core region 111 which are to store a logical zero. The exposed transistors within core region 111 are then programed to this logical zero state, for example, by the implantation of boron ions at approximately 190 Kev to a dosage of approximately 2.5 times $10^{13}$ ions/cm$^2$. This boron implantation causes the threshold voltage of the exposed MOS transistors to be increased to approximately five volts or more, thereby causing the exposed MOS transistors within core region 111 to store a logical zero. Conversely, the MOS transistors within core region 111 which are protected by the photoresist layer (not shown) are sufficiently protected during this ion implantation step to prevent the addition of any significant amount of boron ions. Thus, the threshold voltage of the protected MOS transistors within core region 111 remains at approximately 0.8 volts, and therefore the protected MOS transistors within core region 111 store a logical one.

At this time, entire surface of the device is oxidized, thereby forming an oxide layer (not shown) of approximately 2000Å in thickness over the polycrystalline silicon layers 10 and the regions between adjacent cells. This oxidation is performed, for example by oxidation in wet oxygen at approximately 950°C for approximately 30 minutes.

As shown in Figure 4i, a layer of glass 14 (such as phosphorus doped glass containing approximately 8% phosphorus) is then formed on the surface of the wafer in a well known manner. Contact region 13, which provides electrical contact to source/drain region 7-2, is then formed in the following manner. Referring to Figure 4i, glass layer 14 is patterned, for example, by utilizing well known photolithographic techniques and etching, for example, with buffered HF, thereby to expose that portion of substrate 99 where contact region 13 is to be formed, and thus where the to-be-formed metal interconnect layer 15 (Figure 4j) is to contact regions located in substrate 99. Simultaneously, glass layer 10 is also patterned to expose that portion of polycrystalline silicon layer 10 which is to be contacted by to-be-formed metal interconnect layer 15. N type dopants are then introduced into the exposed portion of substrate 99, thereby forming contact region 13. This introduction of N type dopants is performed, for example, by exposing the wafer to $POCl_3$ at approximately 975°C for approximately 10 minutes, thereby introducing phosphorus dopants into the exposed portion of substrate 99 thus forming contact region 13. Of importance, glass layer 14 and polycrystalline silicon layer 10 serve as a mask preventing the introduction of phosphorus into unexposed portions of substrate 99.

Glass layer 14 is then reflowed, for example, at approximately 1000°C for approximately 15 minutes, thereby to smooth out the rather steep edges formed when openings into glass layer 14 are etched. This reflow insures that the to-be-formed electrical interconnect layer will make a reliable, low resistance connection with desired regions to be contacted. During this glass reflow step, the dopants within polycrystalline silicon layer 10 are also diffused into that portion of substrate 99 which is contacted by polycrystalline silicon layer 10, thereby forming buried contact 11, as previously described. Furthermore, during this glass reflow step, the phosphorus dopants introduced into contact region 13 are diffused, thereby providing the proper distribution of dopants within contact region 13.

As shown in Figure 4j, electrical interconnection is provided to peripheral source/drain contact region 13 and polycrystalline silicon interconnect region 10-3 (word line 33 of Fig. 3a) by the formation of electrical interconnects 15. Electrical interconnects 15 are formed, for example, by forming a layer of aluminum, or an alloy thereof, on the surface of the wafer to a thickness within the range of approximately 9,000 to 11,000Å using well known sputtering techniques, and patterning the aluminum layer 15 utilizing well-known photolithographic techniques and etching with a solution formed of acetic, nitric and phosphoric acids, or by a suitable plasma. Electrical contact is also made to gate 10 by a portion of electrical interconnect layer 15 (not shown). The aluminum interconnect layer 15 is then alloyed, for example at approximately 450°C for approximately 20 minutes in a hydrogen atmosphere, in order to insure a good ohmic contact between the aluminum and the regions being contacted. The entire surface of the device is, if desired, then covered with a scratch protection layer (not shown), such as phosphorous doped glass (vapox) or silicon nitride to a thickness in the range of approximately 9,000 to 11,000Å, as is well-known to those of ordinary skill in the art and openings in the scratch protection layer are formed to allow electrical connection to desired locations on the surface of the device.

In another embodiment of this invention, eraseable programmable read only memories (EPROMs) are fabricated. While EPROMs are well-known in the prior art, such prior art EPROMs are fabricated in much the same way as the ROM shown in the plan view of Figure 2a, with the exception that prior art EPROMs include a so-called "floating gate" for each memory cell contained within the array. These floating gates are located between and insulated from the channel region and the control gate of each memory cell, and electrical charges are stored on selected floating gates in order to program the memory cells associated with these floating gates to either the logical zero or the logical one state. Of importance, each such prior art EPROM memory cell typically comprises a transistor having a plan view as shown in Figure 2a, with electrical contacts required for each source and drain region of each memory cell in the array, with the attendant disadvantages as previously described with regard to prior art ROMS in that each such prior art EPROM memory cell is rather large.

In contrast to prior art EPROMs, the EPROMs constructed in accordance with this invention utilize a plurality of continuous diffused lines in order to form a plurality of memory cell transistors. These diffused lines are continuous, even under word lines, thereby allowing a single electrical contact to provide electrical connection to a plurality of source and drain regions, as previously described with regard to the ROM which is constructed in accordance with this invention.

A plan view of one EPROM constructed in accordance with this invention is shown in Figure 5a. Floating gates 96-1 through 96-3 and 97-1 through 97-3 are formed between, and insulated from, the channel regions of transistors 30-1 through 30-3 and transistors 31-1 through 31-3 and word lines 33 and 133, respectively. In this embodiment, floating gates 96-1 through 96-3 and 97-1 through 97-3 are formed between and extend slightly over each diffused region 7-3 through 7-6, as shown. Although floating gates 96-1 through 96-3 and 97-1 through 97-3 are shown to be somewhat greater in width than word lines 33, 133, respectively, it is understood that this is done for clarity only, with the actual width of the floating gates being substantially the same as, and defined simultaneously with, the width of word lines 33, 133, as is fully described later.

To store a logical one in a memory cell, for example memory cell 30-1, no charge is stored on floating gate 96-1. When no charge is stored on floating gate 96-1, transistor 30-1 turns on when a read voltage Vr, which is greater than the control gate threshold voltage Vt (typically 2.0 volts) of a cell storing a logical one, is applied to its control gate (word line 33). Conversely, in order to store a logical zero in memory cell 30-1, electrons are injected to floating gate 96-1 thereby to provide a negative voltage on floating gate 96-1. This injection of electrons on floating gate 96-1 is accomplished for example, by conventional channel injection of hot electrons. One technique for this electron injection is to place a high voltage (typically 10 to 20 volts) on control gate 33, place a relatively high voltage (typically 10 to 20 volts) on source/drain region 7-4, and grounding source/drain region 7-3. This causes electrons to flow from source/drain region 7-4 to source/drain region 7-3 and, in the process, some electrons are injected from the channel region through gate oxide 1-4 to floating gate 96-1. During this programming of cell 30-1 to a logical zero, sufficient electrons are stored within floating gate 96-1 to increase the control gate threshold voltage Vt of memory cell 30-1 (typically to greater than 5 volts) such that transistor 30-1 will not turn on in response to a read voltage Vr placed on its control gate 33.

In order to prevent undesirable programming of additional cells along word line 33, all other source/drain regions to the right of source/drain region 7-4 (i.e., source/drain regions 7-5, 7-6, etc.), must be deselected by placing a high voltage thereon, thereby preventing the deselected cells to the right of cell 30-1 from conducting and being programmed. Similarly, all other source/drain regions to the left of source/drain region 7-3 must be low, thereby preventing the deselected cells to the left of cell 30-1 from conducting and being programmed.

In order to reprogram transistor 30-1 from a logical zero to a logical one state, electrons are removed from floating gate 96-1. This is accomplished by applying ultraviolet radiation to the entire device for a short time (typically 30 seconds). This reprograms all programmable transistors to the logical one state.

In another embodiment of this invention, as shown in Fig. 5b, floating gates 96-1, 96-2, 96-3, 97-1, 97-2, 97-3 are formed which do not extend between and above both the source and the drain regions of each cell. Thus, for example, to program cell 30-2, diffused region 7-4 is placed high (typically 20 volts or more, control gate 33 is high (typically 20 volts or more), and all other diffused regions 7-3, 7-5, and 7-6 are kept low. Because the hot electron injection takes place near the source/drain region which is at the highest potential, electron injection will only take place in cell 30-2, even though other cells along word line 33 will conduct. This embodiment allows for diffused regions 7-3 through 7-6 of smaller width, due to the elemination of the need to have a minimum spacing between adjacent floating gates above each diffused region. This embodiment also allows deselected diffused lines to be kept low during programming, thereby minimizing substrate current (i.e., current having from diffused regions, active regions, gate regions, etc. to substrate 99).

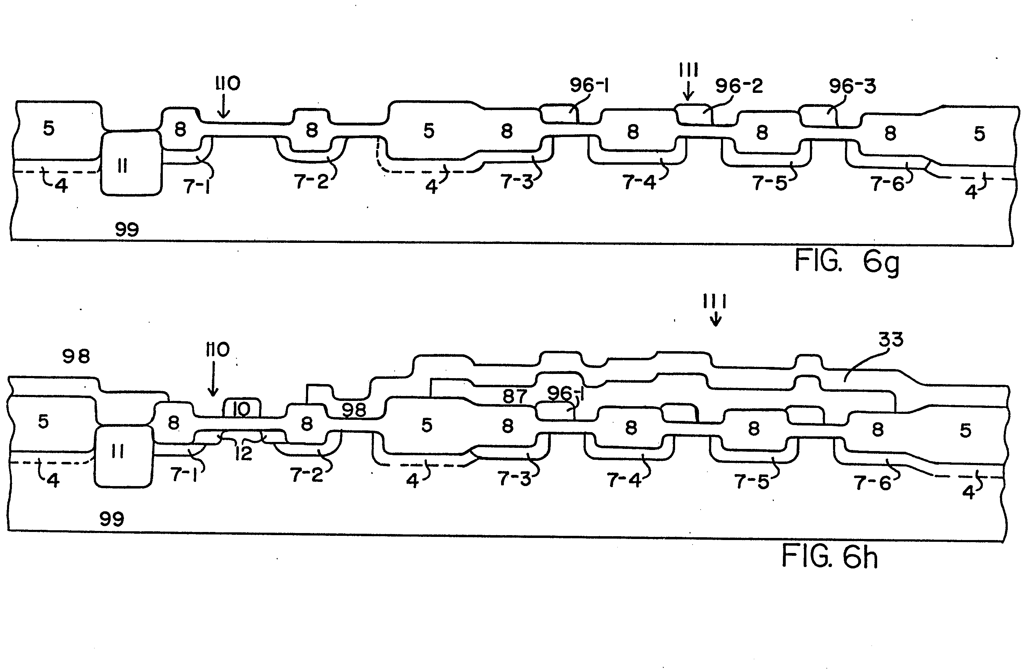

In accordance with one embodiment of this invention, an EPROM is constructed as shown in the cross sectional views of Figures 6a through 6k. The processing steps depicted in Figure 6a through 6f are identical with the processing steps depicted in Figures 4a through 4f, respectively, with the exception that the first implantation in the field region is performed to create a field inversion voltage in the peripheral region of over 20 volts, for example by implanting boron at approximately 100 KEV to a dosage in excess of approximately $1 \times 10^{13}$ atoms/cm$^2$. Figures 4a through 4f have been previously described and thus will not be repeated here. Referring to Figure 6g, a mask (not shown) of photoresist is formed and patterned to expose only those cells which are to be made programmable (i.e., memory cells in the core region 111). If desired, certain transistors in the periphery can also be exposed, and their threshold voltages raised at this time. The threshold voltage of these programmable cells is then raised to approximately 2 volts, for example by the implantation of boron atoms at an energy of approximately 100 KEV to a dosage of approximately $5 \times 10^{13}$ atoms/cm$^2$. This increased threshold voltage causes current flow in the programmable cells to take place closer to the surface of the device, thereby promoting hot electron injection into the floating gates during programming. This reduces the time required to program a memory cell to less than 30 milliseconds.

The photoresist is then removed, and a layer of polycrystalline silicon 96 is formed, for example by chemical vapor deposition, and doped, for example with phosphorus dopant to a resistivity within the range of approximately 30 to 40 ohms/square. Utilizing suitable photolithographic techniques, a mask is formed defining those regions of polycrystalline silicon layer 96 which are to remain to form floating gates 96-1 through 96-3. Exposed portions of polycrystalline silicon layer 96 are then removed, for example by etching with CF$_4$ plasma. At

this time, the width of floating gates 96-1 through 96-3 is greater than their final widths, and greater than the width of to-be-formed polycrystalline silicon word line 33.

Referring to Figure 6h, a layer of insulation 87 is then formed on the surface of the device. This insulation layer 87 comprises, for example, silicon dioxide formed by subjecting the wafer to wet oxygen at a temperature of approximatley 920°C for approximately 30 minutes, thereby forming oxide insulation layer 87 to a thickness of approximately 800 angstroms. Alternatively, silicon nitride or a sandwich formed of silicon nitride and oxides of silicon can be used as insulation layer 87, if desired. A second layer of polycrystalline silicon 98 is then formed over the surface of the device, for example by chemical vapor deposition. This polycrystalline silicon layer 98 is formed to a thickness within the range of approximately 3000 to 4000$\overset{o}{A}$ and is doped with phosphorous dopant to a resistivity within the range of approximately 20 to 40 ohms/ square. As previously described in conjunction with Figures 4a through 4h, contact 11 is formed by diffusion of dopants from polycrystalline silicon layer 98 into substrate 99. Using suitable photolithographic and masking techniques, polycrystalline silicon layer 98 is then patterned for example, by etching with $CF_4$ plasma; as shown to form the desired electrical interconnect pattern, including gate 10 and word line 33.

At this time, portions of oxide layer 87 which are not protected by polycrystalline silicon layer 98 are then removed, for example by etching with buffered HF. Portions of polycrystalline silicon floating gates 96-1 through 96-3 which are not protected by polycrystalline silicon layer 98 and the protective photoresist mask formed thereon are removed, for example by etching with $CF_4$ plasma, thus causing polycrystalline floating gates 96-1 through 96-3 to be self-aligned with polycrystalline layer 98 (word line 33 of Fig. 5b).

Now a channel completion step is performed to form source/drain extensions 12 for the peripheral transistors, as previously described in the description of the ROM fabricated in accordance with this invention. The entire device is then subjected to a field implantation, if desired to increase the field inversion voltage to, for example, in excess of seven volts.

At this time, the entire surface of the device is oxidized, thereby forming an oxide layer (not shown) of approximately 2000Å in thickness over the polycrystalline silicon layers 96 and the regions between adjacent cells. This oxidation is performed, for example by oxidation in wet oxygen at approximately 950°C for approximately 30 minutes.

Referring to Figure 6i, a layer of glass 94 is formed over the surface of the device. This layer of glass 94 comprises, for example, phosphosilicate glass formed by a well-known vapor deposition technique to a thickness of approximately 10,000Å. Utilizing suitable well-known photolithographic techniques, glass layer 94 is then defined, for example with photoresist (not shown) and patterned, for example by etching with buffered HF, to provide vias where to-be-formed metallic interconnects are to make electrical contact with underlying regions, as shown in Fig. 6j. Glass layer 94 is then reflowed, as previously described in conjunction with the first embodiment of this invention, thereby to provide smooth edges where contact vias have been formed. Dopants are also distributed during this step, thus forming contact region 11 as shown.

As shown in Figure 6k, metallic interconnects are then formed, for example, by sputtering a layer 101 of aluminum or an alloy thereof to a thickness of approximately 10,000Å over the surface of the device, patterning the aluminum layer, for example by utilizing well-known photolithographic techniques, and removing undesired portions of the metallic layer by etching with a solution comprising acetic, nitric, and phosphoric acids. The completed device is shown in Figure 6k.

Of course, it is well-known to those of ordinary skill in the art that the first layer of polycrystalline silicon may serve not only as floating gates 96-1 through 96-3 but also as electrical interconnects. Furthermore, it is recognized by those of ordinary skill in the art that metallic interconnect layer 101 may be formed in such a manner as to contact either the diffused regions within substrate 99, desired portions of the first polycrystalline silicon layer, and selected portions of the second layer of polycrystalline silicon, in order to achieve the desired electrical interconnection of circuit elements.

It is also recognized by those of ordinary skill in the art that the order of certain processing steps in each embodiment can be changed without departing from the scope of this invention. As but one example, the field oxide formed between adjacent transistors in the core region (i.e., between word line 33 and bit lines 7-3 and 7-4 of Figs. 31, 51, and 5b) can be formed either after formation of the polycrystalline silicon, as described above, or alternatively can be formed prior to the formation of the polycrystalline silicon word line (and polycrystalline silicon floating gates, in the EPROM). For example, if the field oxide formed between adjacent transistors in the core region is formed before formation of the word line, (and floating gate, in the EPROM) either the location of the word line is masked during this oxide

-29-

formation, or the oxide is selectively removed in those areas where the word lines (and floating gates, in the EPROMS) are to be formed, thereby allowing the word line to be separated from the channel region by only a thin gate oxide, thereby forming the memory core transistors.

While specific embodiments of this invention have been described above, these specific embodiments are intended to serve by way of example only and are not to be construed as limiting the scope of this invention. Numerous other embodiments of this invention will be readily apparent to those with ordinary skill in the art in the light of the teachings of this specification.

CLAIMS

1. A semiconductor memory device having a plurality of cells, each cell comprising an MOS transistor having a source, a drain, a gate, and a channel, and each cell being capable of storing a single binary digit, the device comprising:

a semiconductor substrate of a first conductivity type;

a first doped region of a second conductivity type opposite the first conductivity type:

a second doped region of the second conductivity type;

a plurality of channel regions located between the first and second doped regions; and

a plurality of conductive lines, each conductive line being located above and insulated from an associated one of the channel regions by an insulation layer;

the first doped region serving as the source of each cell, the second doped region serving as the drain of each cell, each conductive line serving as the gate of one of the plurality of cells, and the portion of the substrate between the first and second doped regions and beneath each conductive line serving as the channel of one of the plurality of cells.

2. A semiconductor memory device having a plurality of cells, each cell comprising an MOS transistor having a source, a drain, a control gate, a floating gate, and a channel, and each cell being capable of storing a single binary digit, the device comprising:

a semiconductor substrate of a first conductivity type;

a first doped region of a second conductivity type opposite the first conductivity type;

a second doped region of the second conductivity type;

a plurality of channel regions located between the first and second doped regions;

a plurality of floating gates each located above and insulated from an associated channel region by a first insulation layer; and

a plurality of conductive lines each located above and insulated from an associated one of the floating gates by a second insulation layer;

the first doped region serving as the source of each cell, the second doped region serving as the drain of each cell, each conductive line serving as the control gate of one of the plurality of cells, and the portion of the substrate between the first and second doped regions and beneath each conductive line serving as the channel of one of the plurality of cells.

3. A semiconductor memory device as claimed in claim 1 or 2 having a first electrical contact formed within the first doped region and a second electrical contact formed within the second doped region, thereby allowing electrical connection to the first doped region which serves as the source of each cell and to the second doped region which serves as the drain of each cell.

4. A semiconductor memory device as claimed in claim 1, 2 or 3 comprising additional transistors each having a source, a drain, a gate and a channel, the sources and drains of the additional transistors not being formed as part of the first and second doped regions.

5. A semiconductor memory device having a plurality of R x S cells, each said cell comprising an MOS transistor having a source, a drain, a gate, and a channel, and each cell being capable of storing a single binary digit, the device comprising:

a semiconductor substate of a first conductivity type;

a core region within the substrate and within which the plurality of cells are formed;

a field region surrounding the core region;

a field oxide layer formed on the substrate in the field region;

a plurality of R+1 doped regions of a second conductivity type opposite the first conductivity type formed within the core region;

a plurality of S conductive lines each crossing each of the plurality of doped regions; and

a first insulation layer formed between the plurality of doped regions and the plurality of conductive lines, thereby providing electrical insulation therebetween;

each cell being formed by one of the plurality of doped regions serving as a source, an associated one of the plurality of doped regions serving as a drain, an associated one of the plurality of conductive lines serving as a gate, and that portion of the substrate located between the source and the drain and beneath the gate serving as the channel.

6. A semiconductor memory device having a plurality of R x S cells, each cell comprising an MOS transistor having a source, a drain, a control gate, a floating gate, and a channel, and each cell being capable of storing a single binary digit, the device comprising:

a semiconductor substrate of a first conductivity type;

a core region within the substrate and within which the plurality of cells are formed;

a field region surrounding the core region;

a field oxide layer formed on the substrate in the field region;

a plurality of R+1 doped regions of a second conductivity type opposite the first conductivity type formed within the core region;

a plurality of S conductive lines each crossing

0109853

-33-

each of the plurality of doped regions;

a plurality of R x S floating gates, each floating gate being unequally associated with one of the R x S portions of the S conductive lines lying between the R+1 doped regions, and each floating gate being insulated from the substrate, the plurality of doped regions and the plurality of conductive lines; and

a first insulation layer formed between the plurality of doped regions and the plurality of conductive lines, thereby providing electrical insulation therebetween;

each cell being formed by one of the plurality of doped regions serving as a source, an associated one of the plurality of doped regions serving as a drain, an associated one of the plurality of conductive lines serving as a gate, and that portion of the substrate located between the source and the drain and beneath the gate serving as the channel.

7. A semiconductor memory device as claimed in claim 5 or 6 comprising additional transistors each having a source, a drain, a gate and a channel, the sources and drains of the additional transistors being formed as part of the plurality of R+1 doped regions.

8. A semiconductor memory device as claimed in any preceding claim wherein each cell is surrounded by a field region, the field region being covered by a thick field oxide.

9. A method of forming in a semiconductor substrate of a first conductivity type an integrated circuit memory device having a plurality of cells, each cell comprising an MOS transistor having a source, a drain, a gate, and a channel, and each cell being capable of storing a single binary digit, said method comprising the steps of:

forming in the substrate first and second doped regions of a second conductivity type opposite the first conductivity type;

forming a relatively thin insulation layer over selected portions of the first and second doped regions and over that portion of the substrate located between the first and second doped regions; and

forming a plurality conductive gate regions on the relatively thin insulation layer;

the first doped region forming said source of each of the MOS transistors, the second doped region forming the drain of each of the MOS transistors, and the portion of the substrate beneath each the gate region serving as the channel of its associated MOS transistor.

10. A method of forming in a semiconductor substrate of a first conductivity type an integrated circuit memory device having a plurality of cells, each cell comprising a MOS transistor having a source, a drain, a gate, and a channel, and each cell being capable of storing a single binary digit, the method comprising the steps of:

forming a patterned field oxide layer on the surface of the substrate, thereby leaving selected portions of the substrate free from the field oxide;

forming in the selected portions of the substrate first and second doped regions of a second conductivity type opposite the first conductivity type;

forming a relatively thick insulation layer over a substantial portion of the first and second doped regions;

·forming a relatively thin insulation layer over those portions of the first and second doped regions which are not covered by the relatively thick insulation layer and over that portion of the substrate located between the first and second doped regions; and

forming a plurality conductive gate regions on the relatively thin insulation layer;

the first doped region forming the source of each of the MOS transistors, the second doped region forming the drain of each of the MOS transistors, and the portion of the substrate beneath each gate region serving as the channel of its associated MOS transistor.

11. A method of forming in a semiconductor substrate of a first conductivity type an integrated circuit memory device having a plurality of cells, each cell comprising an MOS transistor having a source, a drain, a control gate, a floating gate, and a channel, and each cell being capable of storing a single binary digit, the method comprising the steps of:

forming in the substrate first and second doped regions of a second conductivity type opposite the first conductivity type;

forming a relatively thin insulation layer over selected portions of the first and second doped regions and over that portion of the substrate located between the first and second doped regions; and

forming a plurality conductive gate regions on the relatively thin insulation layer;

the first doped region forming the source of each of the MOS transistor, the second doped region forms the drain of each MOS transistor, and the portion of the substrate beneath each said gate region serving as the channel of its associated MOS transistor.

12. A method of forming in a semiconductor substrate of a first conductivity type an integrated circuit memory device having a plurality of cells, each cell comprising a MOS transistor having a source, a drain, a control gate, a floating gate, and a channel, and each cell being capable of storing a single binary digit, the method comprising the steps of:

forming a patterned field oxide layer on the surface of the substrate leaving selected portions of the substrate free from the field oxide;

forming in the selected portions of the substrate first and second doped regions of a second conductivity type opposite the first conductivity type;

forming a relatively thick insulation layer over a substantial portion of the first and second doped regions;

forming a relatively thin first insulation layer over those portions of the first and second doped regions which are not covered by the relatively thick insulation layer and over that portion of the substrate located between the first and second doped regions;

forming a plurality floating gate regions on the first insulation layer; and

forming a plurality conductive gate regions on the relatively thin insulation layer;

the first doped region forming the source of each of the MOS transistors, said second doped region forms said drain of each said MOS transistor, and said portion of said substrate beneath each said gate region serves as the channel of its associated MOS transistor.

FIG. 1

FIG. 2a

PRIOR ART

FIG. 2b

PRIOR ART

1/12

0109853

FIG. 3a

FIG. 3b

FIG. 3c

FIG. 4a,6a

FIG. 4b,6b

FIG. 4c,6c

110

III

2   110   2   1   2   III   2   2   2

5   1   5   1

7-1   7-2   7-3   7-4   7-5   7-6

4   4   4

99

FIG. 4d,6d

110   III

1-1   1-2   1-3   1-4   1-5   1-6

5   8   8   5   8   8   8   8   5

4   7-1   7-2   4   7-3   7-4   7-5   7-6   4

99

FIG. 4e,6e

1-2   1-3   1-4   1-5   1-6

5   8   8   5   8   8   8   8   5

4   7-1   7-2   4   7-3   7-4   7-5   7-6   4

99

FIG. 4f,6f

FIG. 4g

FIG. 4h

6/12

0109853

110

III

14

14

14

10

5    10    8    10    8         5    8    8    8    8    5

11         7-1    12  12  7-2   13         7-3    7-4    7-5    7-6

4                                4                                        4

99

FIG. 4i

110

III

10-3    10-4    10-5

15

14

10

5    10    8    10    8    15    5    8    8    8    8    5

11         7-1    12    7-2   13         7-3    7-4    7-5    7-6

4                                4                                        4

99

FIG. 4j

0109853

FIG. 5a

FIG. 5b

FIG. 6g

FIG. 6h

FIG. 6i

FIG. 6j

11/12

0109853

FIG. 6k